(19) **Europäisches Patentamt / European Patent Office / Office européen des brevets**

(11) **EP 4 756 453 A1**

(12) **EUROPEAN PATENT APPLICATION**
published in accordance with Art. 153(4) EPC

(43) Date of publication:
10.06.2026 Bulletin 2026/24

(21) Application number: 24869642.9

(22) Date of filing: 29.03.2024

(51) International Patent Classification (IPC):
*G01R 31/392* (2019.01)     *G01R 31/378* (2019.01)
*G01R 31/367* (2019.01)

(52) Cooperative Patent Classification (CPC):
**G01R 31/367; G01R 31/378; G01R 31/392**

(86) International application number:
**PCT/CN2024/084874**

(87) International publication number:
**WO 2025/066072 (03.04.2025 Gazette 2025/14)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: 26.09.2023 CN 202311264329

(71) Applicant: **Sineng Electric Co., Ltd.**
**Wuxi, Jiangsu 214174 (CN)**

(72) Inventor: **ZHANG, He**
**Wuxi, Jiangsu 214174 (CN)**

(74) Representative: **Bayramoglu et al.**
**Mira Office**
**Kanuni Sultan Süleyman Boulevard 5387**
**Street Beytepe, floor 12, no:50**
**06800 Cankaya, Ankara (TR)**

(54) **TESTING METHOD AND APPARATUS FOR SOH OF LITHIUM BATTERY, AND ELECTRONIC DEVICE AND STORAGE MEDIUM**

(57) This application provides an estimating method and apparatus for an SOH of a lithium battery, and an electronic device and a storage medium, and belongs to the field of energy storage technologies. The estimating method includes: collecting N charging data sequences corresponding to N charging parameters during a charging cycle of a target lithium battery, where N is an integer greater than or equal to 3; processing the N charging data sequences by gray relational analysis to obtain N charging health features; inputting the N charging health features into a pre-trained neural network model to obtain a predicted capacity degradation value; and determining an SOH of the lithium battery based on the capacity degradation value. Input parameters of the pre-trained neural network model are charging health features of N charging parameters obtained from gray relational analysis, such that health features more related to the SOH have higher weights, which is equivalent to weighting an input neural network model in advance, and thus a predicted capacity degradation value that is output by the neural network model is more accurate.

[FIG. 1]

```
Collect N charging data sequences corresponding to N charging
parameters during a charging cycle of a target lithium battery, where N is
an integer greater than or equal to 3                                        — S110

Process the N charging data sequences by gray relational analysis to
obtain N charging health features                                            — S120

Input the N charging health features into a pre-trained neural network
model to obtain a predicted capacity degradation value                       — S130

Determine an SOH of the lithium battery based on the capacity
degradation value                                                            — S140
```

**Description**

This application claims priority to Chinese Patent Application No. 202311264329.4, filed with the China National Intellectual Property Administration on September 26, 2023 and entitled "ESTIMATING METHOD AND APPARATUS FOR SOH OF LITHIUM BATTERY, AND ELECTRONIC DEVICE AND STORAGE MEDIUM", which is incorporated herein by reference in its entirety.

TECHNICAL FIELD

This application belongs to the field of energy storage technologies, and particularly relates to an estimating method and apparatus for an SOH of a lithium battery, and an electronic device and a storage medium.

BACKGROUND TECHNOLOGY

A state of health (SOH) of a lithium battery refers to a health condition or a life status of the lithium battery, which is an important indicator to measure battery performance and remaining life, and is very useful for evaluating and monitoring a state of the lithium battery. The SOH describes a ratio of actual capacity of the lithium battery to initial capacity thereof to reflect a degree of degradation of the battery during use. The SOH is usually expressed as a percentage value ranging from 0% (indicating that the battery has failed) to 100% (indicating that the battery is intact).

As service time of a lithium battery increases, the battery is increasingly aging, and thus capacity of the battery to store charge diminishes. Accurate prediction of the SOH of a lithium battery can reduce the occurrence of safety incidents caused by battery aging and can provide a basis for retirement decisions, thereby ensuring the stability and safety of the lithium battery during its use. Therefore, accurate prediction of the SOH of the lithium battery has become an issue to be addressed currently.

CONTENT OF THE INVENTION

This application provides an estimating method and apparatus for an SOH of a lithium battery, and an electronic device and a storage medium, which can address at least a part of the issue of accurately predicting the SOH of the lithium battery.

According to a first aspect, an embodiment of this application provides an estimating method for an SOH of a lithium battery, including:

collecting N charging data sequences corresponding to N charging parameters during a charging cycle of a target lithium battery, where N is an integer greater than or equal to 3;
processing the N charging data sequences by gray relational analysis to obtain N charging health features;
inputting the N charging health features into a pre-trained neural network model to obtain a predicted capacity degradation value; and
determining an SOH of the lithium battery based on the capacity degradation value.

It should be understood that input parameters of the pre-trained neural network model are charging health features of N charging parameters obtained from gray relational analysis, such that health features more related to the SOH have higher weights, which is equivalent to weighting an input neural network model in advance, and thus a predicted capacity degradation value that is output by the neural network model is more accurate.

According to a second aspect, an embodiment of this application provides an estimating apparatus for an SOH of a lithium battery, including:

a charging data collection module, configured to collect N charging data sequences corresponding to N charging parameters during a charging cycle of a target lithium battery, where N is an integer greater than or equal to 3;
a charging health feature obtaining module, configured to process the N charging data sequences by gray relational analysis to obtain N charging health features;
a predicted capacity degradation value determining module, configured to input the N charging health features into a pre-trained neural network model to obtain a predicted capacity degradation value; and
a lithium battery SOH determining module, configured to determine an SOH of the lithium battery based on the capacity degradation value.

According to a third aspect, an embodiment of this application provides an electronic device, including:
a memory, a processor, and a computer program stored in the memory and capable of running on the processor, when the processor executes the computer program, the method steps according to the first aspect are implemented.

According to a fourth aspect, an embodiment of this application provides a computer-readable storage medium, where the computer-readable storage medium stores a computer program, and the computer program is executed by a processor to implement the method steps according to the first aspect.

According to a fifth aspect, an embodiment of this application provides a computer program product. When the computer program product runs on an electronic device, the electronic device is enabled to perform the method steps according to the first aspect.

It may be understood that for beneficial effects of the second aspect to the fifth aspect, refer to the related descriptions in the first aspect. Details are not described herein again.

DESCRIPTION OF THE DRAWINGS

To describe the technical solutions in the embodiments of this application or in the prior art more clearly, the following briefly describes the accompanying drawings required for describing the embodiments or the prior art. Clearly, the accompanying drawings in the following description show some embodiments of this application, and a person of ordinary skill in the art may still derive other drawings from these accompanying drawings without creative efforts.

FIG. 1 is a schematic flowchart of an estimating method for an SOH of a lithium battery according to an embodiment of this application;
FIG. 2 is a schematic flowchart of performing error compensation on a BP neural network model by using a gray model according to an embodiment of this application;
FIG. 3 is a schematic diagram of a structure of an estimating apparatus for an SOH of a lithium battery according to an embodiment of this application; and
FIG. 4 is a schematic diagram of a structure of an electronic device according to an embodiment of this application.

IMPLEMENTATIONS OF THE INVENTION

In the following descriptions, for the purpose of description instead of limitation, specific details such as a specific system structure and a technology are proposed, to provide a thorough understanding of embodiments of this application. However, it should be understood by a person skilled in the art that this application may also be implemented in another embodiment without these specific details. In other cases, detailed descriptions about a well-known system, apparatus, circuit, and method are omitted to prevent unnecessary details from obscuring the description of this application.

It should be understood that when being used in the specification and the appended claims of this application, the term "include" indicates presence of a described feature, entirety, step, operation, element, and/or component, but does not rule out presence or addition of one or more other features, entireties, steps, operations, elements, components, and/or sets thereof.

It should also be understood that the term "and/or" used in this specification and the appended claims of this application means any combination and all possible combinations of one or more of listed associated items, and these combinations are included.

As used in this specification and the appended claims of this application, the term "if" may be interpreted according to the context as "when...", "once", "determining in response to", or "detecting in response to". Similarly, the phrase "if it is determined that" or "if [a described condition or event] is detected" may be interpreted according to the context as "once it is determined that", "it is determined that in response to", "once [a described condition or event] is detected", or "[a described condition or event] is detected in response to".

In addition, in the descriptions of this specification and the appended claims of this application, the terms "first", "second", "third", and the like are merely used to distinguish between the descriptions, and should not be understood as indicating or implying relative importance.

Reference to "one embodiment" or "some embodiments" described in the specification of this application means that one or more embodiments of this application include a specific feature, structure, or feature described with reference to the embodiment. Therefore, statements such as "in one embodiment", "in some embodiments", or "in some other embodiments" that appear in different parts of this application do not necessarily refer to same embodiments, but mean "one or more but not all embodiments" unless otherwise specifically emphasized in another manner. The terms "include", "comprise", and "have", and variants thereof all mean "include but are not limited to", unless otherwise specifically emphasized in another manner.

Before an estimating method for an SOH of a lithium battery according to embodiments of this application is described, for ease of understanding the embodiments of this application, the following describes relevant concepts involved in the embodiments of this application.

Gray relational analysis is a method used to study and evaluate correlation among a plurality of factors. The method is applicable to analysis in situations where data is incomplete, ambiguous, or lacks historical data.

A gray model is a system modeling method used to handle situations where data is incomplete, ambiguous, or lacks historical data. Based on the gray system theory, the gray model aims to reveal inherent laws behind data by analyzing and predicting data sequences, thereby providing decision support and predictive capabilities.

A whitenization differential equation is a class of differential equations whose purpose is to convert an original equation into a simpler differential equation through transformation. The whitenization differential equation uses a method known as "whitenization variables" to eliminate or reduce nonlinear terms, higher order terms, or other intractable characteristics in the original equation.

A BP neural network, also referred to as a backpropagation neural network, is an artificial neural network model used to address issues such as classification and regression. The BP neural network consists of a plurality of nodes (neurons) and connections, and is usually divided into an input layer, a hidden layer, and an output layer. Each node has an activation function used to convert an input signal into an output signal. Each connection has a weight used to adjust intensity of signal transmission.

A charging cycle of a lithium battery is a process of restoring a battery from a discharged state to a fully charged state, and usually includes the following states: pre-charging, constant current charging, constant voltage charging, charging cut-off, and the like.

This application provides a method for online estimation of an SOH of a lithium-ion battery based on a neural network model, aiming at improving estimation accuracy of the SOH in the conventional technology. In this application, parameters related to voltage, current, and temperature are collected at different charging stages, and parameter sequences are extracted by gray relational analysis to obtain health features of the battery. A trained BP neural network is used to take charging health features of the lithium battery that are extracted by using the gray relational analysis as an input to calculate a capacity degradation value of the lithium-ion battery. Among the charging health features of the lithium battery that are extracted by using the gray relational analysis, health features more related to the SOH have higher weights, which is equivalent to weighting an input neural network model in advance, so that the estimation of the SOH is more accurate.

Embodiment 1

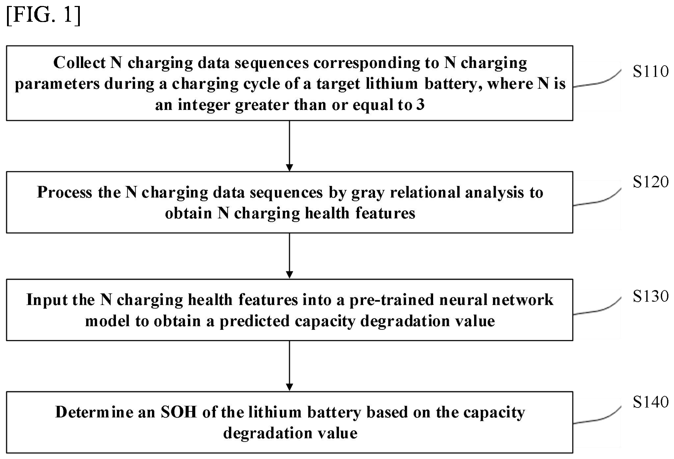

FIG. 1 shows an estimating method for an SOH of a lithium battery according to an embodiment of this application. The method is applied to an electronic device for estimating an SOH of a lithium battery, and may be implemented by software and/or hardware of the electronic device. As shown in FIG. 1, the method includes step S110 to step S140. Specific implementation principles for the steps are as follows.

S110: Collect N charging data sequences corresponding to N charging parameters during a charging cycle of a target lithium battery, where N is an integer greater than or equal to 3.

In some embodiments, the target lithium battery is a lithium battery under estimating for which an SOH needs to be obtained. During a charging cycle of the target lithium battery, N charging data sequences corresponding to N charging parameters are collected, where N is an integer greater than or equal to 3, that is, for each charging parameter, a corresponding charging data sequence is collected. It should be noted that a quantity k of elements in the charging data sequence may be selected according to an actual situation. Specifically, the N charging parameters may be respectively collected and fitted into curves, and a curve corresponding to each parameter is sampled based on a preset sampling step to obtain a corresponding charging data sequence. It may be understood that a process of obtaining a charging sequence corresponding to a charging parameter may be as follows: a currently sampled parameter is a $k^{th}$ sampled parameter, which, together with previously sampled k-1 parameters, constitutes a charging data sequence corresponding to the charging parameter.

The N charging parameters include at least three of the following parameters: constant voltage charging time $A_1$, constant current charging time $A_2$, a ratio $A_1/A_2$ of constant voltage charging time to constant current charging time, an integral value of constant voltage charging current $I_1$ over time, an integral value of constant current charging current $I_2$ over time, an integral value of constant voltage charging temperature $T_1$ over time, an integral value of constant current charging temperature $T_2$ over time, a maximum slope $K_1$ of a charging voltage versus time curve, a maximum slope $K_2$ of a charging current versus time curve, an integral value of constant voltage charging temperature $T_1$ over time/an integral value of constant voltage charging current $I_1$ over time, and an integral value of constant current charging temperature $T_2$ over time/an integral value of constant current charging current $I_2$ over time. The N charging parameters include at least parameters related to voltage, current, and temperature. In some specific examples, at least one parameter related to voltage, current, and temperature is selected, respectively. Certainly, if all the above 11 charging parameters are selected, the obtained SOH may be more accurate.

A lithium battery exhibits uncertain operating conditions during discharge. Indirect health features of the lithium-ion battery are usually extracted from a charging stage. A charging process of a lithium-ion battery that is currently used involves constant current charging followed by constant voltage charging. Voltage, current, and temperature may be collected at different charging stages, and charging health features are extracted based on collected information.

S120: Process the N charging data sequences by gray relational analysis to obtain N charging health features.

In some embodiments, the step may specifically include the following steps:

performing dimensionless processing on the N data sequences, using a capacity sequence obtained from the dimensionless processing as a reference sequence $X_0 = \{x_0(k)\}$, and setting a charging data sequence as a comparison sequence $X_i = \{x_i(k)\}$, where i=1, 2, 3..., N;

based on a relational coefficient formula

$$\xi_i(k) = \min_{\forall i,k}|x_0(k) - x_i(k)| + \rho \max_{\forall i,k}|x_0(k) - x_i(k)| \Big/ |x_0(k) - x_i(k)| + \rho \max_{\forall i,k}|x_0(k) - x_i(k)|$$, solving a

gray relational coefficient $\xi_i(k)$ for each charging data sequence and the capacity sequence; and

based on a formula

$$\gamma_i = \frac{1}{n}\sum_{k=1}^{n}\xi_i(k)$$

solving an average value of gray relational coefficients of an ith charging data sequence, and using the average value as a charging health feature of the ith charging data sequence;

where, n denotes a quantity of data in the sequence; and $\rho$ is a resolution coefficient, ranging from [0, 1]. Specifically, $\rho$ may be 0.5.

S130: Input the N charging health features into a pre-trained neural network model to obtain a predicted capacity degradation value.

The pre-trained neural network model is a BP neural network model, where a quantity of input nodes of the BP neural network model is N, and a quantity of output node is 1. In some embodiments, there is one hidden layer, and a quantity of nodes in the hidden layer is 8.

Specifically, the N charging health features are input into the pre-trained neural network model. Because weights among nodes of the pre-trained neural network model have been determined, a predicted capacity degradation value may be output.

S140: Determine an SOH of the lithium battery based on the capacity degradation value.

In some implementations, specifically, by using a formula

$$S\widehat{O}H = \frac{C - \hat{O}_k}{C} \times 100\%$$

an estimated value SÔH of the lithium battery is calculated,

where C is initial capacity of the lithium battery, and $\hat{O}_k$ is a predicted capacity degradation value obtained from the pre-trained neural network model.

It should be understood that the gray system theory proposes a concept of performing gray relational analysis on subsystems, aiming to seek a numerical relationship among the subsystems within a system by using a method. Therefore, gray relational analysis provides a quantitative measure for development and change trends of a system, and is thus highly suitable for dynamic process analysis.

Input parameters of the pre-trained neural network model are charging health features of N charging parameters that are obtained by gray relational analysis, such that health features more related to the SOH have higher weights, which is equivalent to weighting an input neural network model in advance, and thus a predicted capacity degradation value that is output by the neural network model is more accurate.

Embodiment 2

Before the step of collecting N charging data sequences corresponding to N charging parameters during a charging cycle of a target lithium battery, the method further includes a process of training the BP neural network model.

In some embodiments, multiple groups of charging data sequence samples corresponding to the N charging parameters are collected in a complete charging cycle, and a capacity degradation value sample corresponding to each group of the charging data sequence samples is obtained, where each group of the charging data sequence samples includes N charging data sequences. each group of the charging data sequence samples is processed by gray relational analysis to obtain a corresponding charging health feature. The BP neural network model is trained by using the charging health feature corresponding to each group of the charging data sequence samples as an input value of an input node of the BP neural network model and by using a capacity degradation value sample as an output value of the BP neural network model, and error compensation is performed on the BP neural network model by using a gray model during training to obtain the pre-trained neural network model.

Specifically, multiple groups of charging data sequence samples corresponding to multiple groups of N charging parameters may be obtained during a plurality of charging cycles, and at the same time, capacity degradation value samples corresponding to each group of the charging data sequence samples may be estimated.

For an example of performing gray relational analysis on the multiple groups of charging data sequence samples corresponding to the N charging parameters, reference may be made to another embodiment of this application. Details are not described herein again.

The BP neural network has a simple structure, and when a reasonable correction algorithm is selected, an update speed is fast, which can meet a requirement for real-time prediction of the SOH. Therefore, the BP neural network is used to predict an SOH of a battery.

During training of a neural network, charging health features of a lithium battery are extracted by gray relational analysis as an input of a neural network algorithm, and a capacity degradation value is used as an output to construct a neural network model. A specific process of constructing the neural network model includes the following steps.

Step A: Initialize the neural network. Quantities of nodes of neurons in an input layer and an output layer are selected based on dimensions of input and output quantities. That is, a quantity of nodes in the input layer is determined based on a quantity of charging parameters N selected in the embodiment. For example, if the quantity of charging parameters N is 11, the quantity of nodes in the input layer is 11, the quantity of nodes in the output layer is 1, and a quantity of nodes in a hidden layer is set to be 8. Quantities of layers and nodes of the hidden layer may be selected according to an actual situation.

Connection weights and thresholds between adjacent layers are initialized, a suitable training objective and a learning rate are set, and an appropriate neuron activation function is selected.

Step B: Calculate an output of the hidden layer based on the selected neuron activation function. A formula for calculating the output is as follows:

$$H_j = f\left(\sum_{i=1}^{n} \omega_i x_i - b_j\right)$$

$$f(x) = \frac{1 - e^{-2x}}{1 + e^{-2x}}$$

where $H_j$ is an output of a $j^{th}$ neural node in the hidden layer, $x_i$ is an $i^{th}$ input of the input layer, $b_j$ is a threshold of a $j^{th}$ neuron in the hidden layer, and $f(x)$ is an activation function of the hidden layer.

Step C: Calculate an output of the output layer. A formula for calculating the output is as follows:

$$O_k = \sum_{j=1}^{l} \omega_{i,k} H_j - a_k$$

where $O_k$ is an output of a $k^{th}$ neural node in the output layer, and $a_k$ is a threshold of the $k^{th}$ neural node in the output layer.

Step D: Calculate a neural network estimation error. A formula for calculating the error is as follows:

$$e_k = Y_k - O_k$$

where $e_k$ is an output error of the $k^{th}$ neural node in the output layer, and $Y_k$ is an expected output of the $k^{th}$ node in the output layer.

It should be noted that when the BP neural network has one output node, in the above steps of training the neural network, k is 1.

Step E: Update weights and thresholds by using a steepest descent method.

Step F: Determine whether iteration of the neural network algorithm has ended, and if not, return to step B.

The BP neural network has a simple structure, and when a reasonable correction algorithm is selected, an update speed is fast, which can meet a requirement for real-time prediction of the SOH. Therefore, the BP neural network is used to predict an SOH of a battery.

Embodiment 3

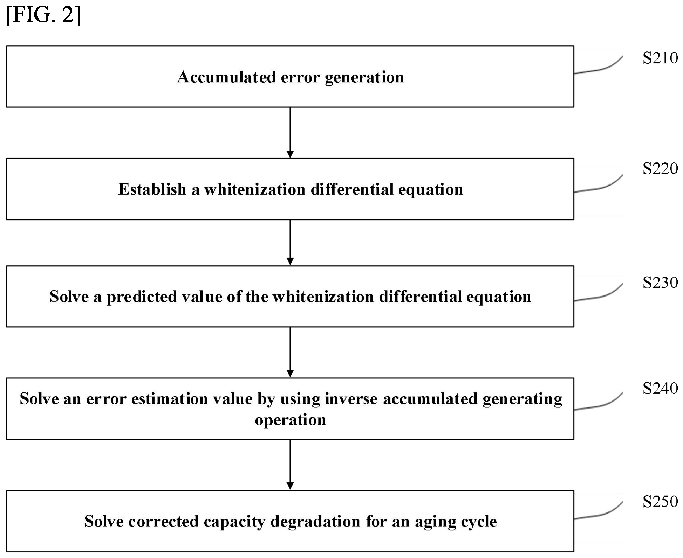

On the basis of Embodiment 2, as shown in FIG. 2, error compensation is performed on the BP neural network model by using a gray model, that is, error compensation is performed on a neural network estimation error e = Y - O of a current output.

Step S210 to step S220 are included.

Step 1 (S210): Accumulated error generation.

First k-1 neural network estimation errors $err_1$, $err_2$ ..., $err_{k-1}$ of a current $k^{th}$ output of the BP neural network model are obtained as an original sequence, and a predicted value $E\hat{R}R_1 = err_1$ is set.

Specifically, an accumulated generating operation may be performed on the original sequence by using a formula

$$\mathrm{ERR}_{k-1} = \sum\nolimits_{j=1}^{k-1} \mathrm{err}_j .$$

Step 2 (S220): Establish a whitenization differential equation.

$$\frac{d\mathrm{ERR}_{k-1}}{d(k-1)} + a\mathrm{ERR}_{k-1} = b$$

To-be-determined parameters a and b are determined by using a least square method. Specifically, the following formula is used:

parameter vector â = [a, b]$^T$,

$$\hat{a} = (B^T \times B)^{-1} \times B^T \times Y_{k-1},$$

$$B = \begin{bmatrix} -0.5 \times (ERR_2 + ERR_1) & 1 \\ -0.5 \times (ERR_3 + ERR_2) & 1 \\ \vdots & \vdots \\ -0.5 \times (ERR_{k-1} + ERR_{k-2}) & 1 \end{bmatrix},$$

$$Y_k = \begin{bmatrix} err_2 & err_3 & ... & err_{k-1} \end{bmatrix}^T.$$

Step 3 (S230): Solve a predicted value $E\hat{R}R_k$ of the whitenization differential equation:

$$\widehat{\mathrm{ERR}}_k = \left( \mathrm{err}_1 - \frac{b}{a} \right) \times e^{-a(k-1)} + \frac{b}{a} .$$ Step 4 (S240): Solve an error estimation value by using inverse accumulated generating operation.

Specifically, an estimated value $e\hat{r}r_k$ of a current corrected capacity degradation estimation error $e\hat{r}r_k$ is solved by using a formula $e\hat{r}r_k = E\hat{R}R_k - E\hat{R}R_{k-1}$.

Step 5 (S250): Solve corrected capacity degradation for an aging cycle.

Specifically, corrected capacity degradation for a $k^{th}$ aging cycle of a current output of the BP neural network model is calculated by using a formula $\hat{O}_k = O_k + e\hat{r}r_k$, where k is times of sampling.

To improve estimation accuracy of the SOH, a feedforward error compensation system of the gray model is designed during training of the BP neural network. Based on historical capacity data and estimated capacity degradation, a capacity degradation estimation error is calculated. The gray model is used to correct capacity degradation at each step, so that prediction of the SOH by the trained BP neural network is more accurate.

Embodiment 4

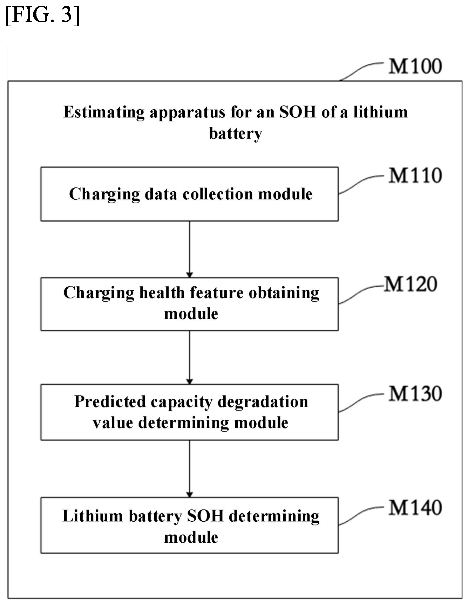

Corresponding to the estimating method for an SOH of a lithium battery shown in FIG. 1, FIG. 3 shows an estimating apparatus M100 for an SOH of a lithium battery according to an embodiment of this application. The estimating apparatus includes:

a charging data collection module M110, configured to collect N charging data sequences corresponding to N charging parameters during a charging cycle of a target lithium battery, where N is an integer greater than or equal to 3;
a charging health feature obtaining module M120, configured to process the N charging data sequences by gray relational analysis to obtain N charging health features;
a predicted capacity degradation value determining module M130, configured to input the N charging health features into a pre-trained neural network model to obtain a predicted capacity degradation value; and
a lithium battery SOH determining module M140, configured to determine an SOH of the lithium battery based on the capacity degradation value.

It should be noted that for ease and brevity of description, for a specific working process of the estimating apparatus for an SOH of the lithium battery, reference may be made to a corresponding process of the estimating method for an SOH of the lithium battery. Details are not described herein again.

It may be understood that various implementations, combinations of implementations, and beneficial effects thereof in the foregoing embodiments are also applicable to this embodiment. Details are not described herein again.

Embodiment 5

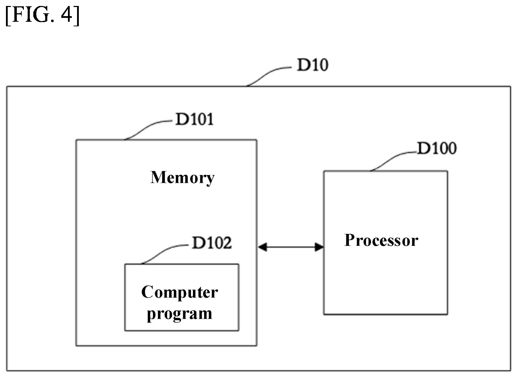

FIG. 4 is a schematic diagram of a structure of an electronic device according to an embodiment of this application. As shown in FIG. 4, an electronic device D10 in this embodiment includes: at least one processor D100 (only one processor is shown in FIG. 4), a memory D101, and a computer program D102 stored in the memory D101 and capable of running on the at least one processor D100. When the processor D100 executes the computer program D102, the steps in any one of the foregoing method embodiments are implemented.

The electronic device D10 may be a computing device such as a desktop computer, a notebook computer, a handheld computer, or a cloud server. The electronic device may include, but is not limited to, the processor D100 and the memory D101. It may be understood by a person skilled in the art that FIG. 4 is merely an example of the electronic device D10 and does not constitute any limitation on the electronic device D10. The electronic device may include more or fewer components than those illustrated, or combine some components, or different components. For example, the electronic device may further include an input/output device, a network access device, and the like.

The processor D100 may be a central processing unit (CPU), or the processor D100 may be another general-purpose processor, a digital signal processor (DSP), an application specific integrated circuit (ASIC), a field-programmable gate array (FPGA) or another programmable logic device, a discrete gate or a transistor logic device, a discrete hardware component, or the like. The general-purpose processor may be a microprocessor, or the processor may be any conventional processor, or the like.

In some embodiments, the memory D101 may be an internal storage unit of the electronic device D10, such as a hard disk or memory of the electronic device D10. In some other embodiments, the memory D101 may alternatively be an external storage device of the electronic device D10, for example, a plug-in hard disk, a smart media card (SMC), a secure digital (SD) card, or a flash card that is configured on the electronic device D10. Further, the memory D101 may alternatively include both an internal storage unit and an external storage device of the electronic device D10. The memory D101 is configured to store an operating system, an application, a boot loader (BootLoader), data, another program, and the like, for example, program code of the computer program. The memory D101 may further be configured to temporarily store data that has been output or that is to be output.

It should be understood that sequence numbers of the steps in the foregoing embodiments do not mean an execution sequence. The execution sequence of the processes should be determined based on functions and internal logic of the processes, and should not constitute any limitation on the implementation processes of the embodiments of this application.

It may be clearly understood by a person skilled in the art that, for ease and brevity of description, division of the foregoing functional units and modules is merely used as an example for description. In an actual application, the foregoing functions may be allocated to different functional units and modules based on a requirement, that is, an internal structure of the apparatus is divided into different functional units or modules, to complete all or some of the functions described above. The functional units or modules in the embodiments may be integrated into one processing unit, each unit may exist alone physically, or two or more units are integrated into one unit. The foregoing integrated unit may be implemented in a form of hardware, or may be implemented in a form of a software functional unit. In addition, specific names of the functional units and modules are also used for ease of mutual distinction, and are not used to limit the protection scope of this application. For a specific working process of each of the units and the modules in the foregoing system, refer to a corresponding process in the foregoing method embodiments. Details are not described herein again.

An embodiment of this application further provides a computer-readable storage medium. The computer-readable storage medium stores a computer program, and when the computer program is executed by a processor, the steps in the foregoing method embodiments may be implemented.

An embodiment of this application provides a computer program product. When the computer program product runs on an electronic device, the electronic device is enabled to implement the steps in the foregoing method embodiments.

When an integrated unit is implemented in a form of a software functional unit and sold or used as an independent product, the integrated unit may be stored in a computer-readable storage medium. Based on such an understanding, in this application, all or some of the procedures in the methods in the foregoing embodiments may be implemented by a computer program instructing related hardware. The computer program may be stored in a computer-readable storage medium. When the computer program is executed by a processor, the steps in the foregoing method embodiments may be implemented. The computer program includes computer program code, and the computer program code may be in a source code form, an object code form, an executable file form, some intermediate forms, or the like. The computer-readable medium may include at least any entity or apparatus capable of adding computer program code to a photographing apparatus/terminal device, a recording medium, a computer memory, a read-only memory (ROM), a random access memory (RAM), an electrical carrier signal, a telecommunications signal, and a software distribution medium, for example, a USB flash drive, a removable hard disk, a magnetic disk, or an optical disc. In some jurisdictions, the computer-readable medium cannot be an electrical carrier signal or a telecommunications signal according to legislation and patent practice.

In the foregoing embodiments, the descriptions of the embodiments have respective focuses. For a part that is not detailed or described in an embodiment, refer to related descriptions in other embodiments.

A person of ordinary skill in the art may be aware that the units and the algorithm steps in the examples described with reference to the embodiments disclosed in this specification can be implemented by using electronic hardware or a combination of computer software and electronic hardware. Whether these functions are performed by hardware or software depends on specific applications and design constraints of the technical solutions. A person skilled in the art may use different methods to implement the described functions for each particular application, but it should not be considered that such implementation goes beyond the scope of this application.

In the embodiments provided in this application, it should be understood that the disclosed apparatus/network device and method may be implemented in another manner. For example, the described apparatus/network device embodiment is merely an example. For example, division of the modules or units is merely logical function division. In an actual implementation, there may be another division manner. For example, a plurality of units or components may be combined or integrated into another system, or some features may be ignored or not performed. In addition, the displayed or discussed mutual coupling, direct coupling, or communication connection may be implemented through some interfaces, and indirect coupling or a communication connection of the apparatuses or units may be in an electrical, mechanical, or another form.

The units described as separate parts may or may not be physically separate, and parts displayed as units may or may not be physical units, may be located at one position, or may be distributed on multiple network units. Some or all of the units may be selected based on actual requirements to achieve the objectives of the solutions of the embodiments.

The foregoing embodiments are merely intended to describe the technical solutions of this application, but are not to limit this application. Although this application is described in detail with reference to the foregoing embodiments, it should be understood by a person of ordinary skill in the art that they may still make modifications to the technical solutions described in the foregoing embodiments or make equivalent replacements to some technical features thereof, without departing from the spirit and scope of the technical solutions of embodiments of this application, and these modifications and replacements shall fall within the protection scope of this application.

The disclosed embodiments are merely preferred embodiments of this application, and certainly are not intended to limit the claimed scope of this application. Therefore, equivalent variations made in accordance with the claims of this application shall fall within the scope of this application.

**Claims**

1. An estimating method for an SOH of a lithium battery, comprising:

> collecting N charging data sequences corresponding to N charging parameters during a charging cycle of a target lithium battery, wherein N is an integer greater than or equal to 3;
> processing the N charging data sequences by gray relational analysis to obtain N charging health features;
> inputting the N charging health features into a pre-trained neural network model to obtain a predicted capacity degradation value; and
> determining an SOH of the lithium battery based on the capacity degradation value.

2. The method of claim 1, wherein the N charging parameters comprise at least three of the following parameters:

constant voltage charging time $A_1$, constant current charging time $A_2$, a ratio $A_1/A_2$ of constant voltage charging time to constant current charging time, an integral value of constant voltage charging current $I_1$ over time, an integral value of constant current charging current $I_2$ over time, an integral value of constant voltage charging temperature $T_1$ over time, an integral value of constant current charging temperature $T_2$ over time, a maximum slope $K_1$ of a charging voltage versus time curve, a maximum slope $K_2$ of a charging current versus time curve, an integral value of constant voltage charging temperature $T_1$ over time/an integral value of constant voltage charging current $I_1$ over time, and an integral value of constant current charging temperature $T_2$ over time/an integral value of constant current charging current $I_2$ over time.

3. The method of claim 1, wherein the processing the N charging data sequences by gray relational analysis to obtain N charging health features comprises:

performing dimensionless processing on the N data sequences, using a capacity sequence obtained from the dimensionless processing as a reference sequence $X_0 = \{x_0(k)\}$, and setting a charging data sequence as a comparison sequence $X_i = \{x_i(k)\}$, where i=1, 2, 3..., N;
based on a relational coefficient formula

$$\xi_i(k) = \min_{\forall i,k}|x_0(k) - x_i(k)| + \rho \max_{\forall i,k}|x_0(k) - x_i(k)| / |x_0(k) - x_i(k)| + \rho \max_{\forall i,k}|x_0(k) - x_i(k)| \quad ,$$

solving a gray relational coefficient $\xi_i(k)$ for each charging data sequence and the capacity sequence; and
based on a formula

$$\gamma_i = \frac{1}{n}\sum_{k=1}^{n}\xi_i(k)$$

solving an average value of gray relational coefficients of an $i^{th}$ charging data sequence, and using the average value as a charging health feature of the $i^{th}$ charging data sequence; where
n denotes a quantity of data in the sequence; and $\rho$ is a resolution coefficient, ranging from [0, 1].

4. The method of claim 1, wherein the pre-trained neural network model is a BP neural network model, with a quantity of input nodes of the BP neural network model being N, and a quantity of output node being 1;
before the step of collecting N charging data sequences corresponding to N charging parameters during a charging cycle of a target lithium battery, the method further comprises:

collecting, in a complete charging cycle, multiple groups of charging data sequence samples corresponding to the N charging parameters, and obtaining a capacity degradation value sample corresponding to each group of the charging data sequence samples, wherein each group of the charging data sequence samples comprises N charging data sequences;
processing each group of the charging data sequence samples by gray relational analysis to obtain a corresponding charging health feature; and
training the BP neural network model by using the charging health feature corresponding to each group of the charging data sequence samples as an input value of an input node of the BP neural network model and by using a capacity degradation value sample as an output value of the BP neural network model, and performing error compensation on the BP neural network model by using a gray model during training to obtain the pre-trained neural network model.

5. The method of claim 4, wherein the performing error compensation on the BP neural network model by using a gray model comprises:

step 1: obtaining first k-1 output errors $err_1$, $err_2$..., $err_{k-1}$ of a current $k^{th}$ output of the BP neural network model as an original sequence, and setting a predicted value $\hat{ERR}_1 = err_1$;
performing an accumulated generating operation on the original sequence by using a formula
$$ERR_{k-1} = \sum_{j=1}^{k-1} err_j \,;$$

step 2: establishing a whitenization differential equation model

$$\frac{dERR_{k-1}}{d(k-1)} + aERR_{k-1} = b,$$

determining to-be-determined parameters a and b by using a least square method;
step 3: solving a predicted value $E\hat{R}R_k$ of the whitenization differential equation:

$$E\widehat{R}R_k = \left(err_1 - \frac{b}{a}\right) \times e^{-a(k-1)} + \frac{b}{a};$$

step 4: solving an estimated value $e\hat{r}r_k$ of a current corrected capacity degradation estimation error $e\hat{r}r_k$ by using a formula $e\hat{r}r_k = E\hat{R}R_k - E\hat{R}R_{k-1}$; and
step 5: calculating, by using a formula $\hat{O}_k = O_k + e\hat{r}r_k$, corrected capacity degradation for a $k^{th}$ aging cycle of a current output of the BP neural network model;
wherein
k is times of sampling.

6. The method of claim 5, wherein the determining to-be-determined parameters a and b by using a least square method comprises: calculating the parameters a and b by using the following formula:

$$\text{parameter vector } \hat{a} = [a, b]^{\mathrm{T}},$$

$$\hat{a} = (B^T \times B)^{-1} \times B^T \times Y_{k-1},$$

$$B = \begin{bmatrix} -0.5 \times (ERR_2 + ERR_1) & 1 \\ -0.5 \times (ERR_3 + ERR_2) & 1 \\ \vdots & \vdots \\ -0.5 \times (ERR_{k-1} + ERR_{k-2}) & 1 \end{bmatrix},$$

$$Y_k = [err_2 \quad err_3 \quad ... \quad err_{k-1}]^T.$$

7. The method of claims 1 to 6, wherein the determining an SOH of the lithium battery based on the capacity degradation value comprises:

by using a formula

$$\text{SOH} = \frac{C - \widehat{O}_k}{C} \times 100\%$$

calculating an estimated value SOH of the lithium battery,
where C is initial capacity of the lithium battery, and $\hat{O}_k$ is a predicted capacity degradation value obtained from the pre-trained neural network model.

8. An estimating apparatus for an SOH of a lithium battery, comprising:

a charging data collection module, configured to collect N charging data sequences corresponding to N charging parameters during a charging cycle of a target lithium battery, wherein N is an integer greater than or equal to 3;
a charging health feature obtaining module, configured to process the N charging data sequences by gray relational analysis to obtain N charging health features;
a predicted capacity degradation value determining module, configured to input the N charging health features into a pre-trained neural network model to obtain a predicted capacity degradation value; and
a lithium battery SOH determining module, configured to determine an SOH of the lithium battery based on the capacity degradation value.

9. An electronic device, comprising a memory, a processor, and a computer program stored in the memory and capable of running on the processor, wherein when the processor executes the computer program, the method according to any one of claims 1 to 7 is implemented.

10. A computer-readable storage medium, wherein the computer-readable storage medium stores a computer program, and when the computer program is executed by a processor, the method according to any one of claims 1 to 7 is implemented.

[FIG. 1]

| Collect N charging data sequences corresponding to N charging parameters during a charging cycle of a target lithium battery, where N is an integer greater than or equal to 3 | S110 |

| Process the N charging data sequences by gray relational analysis to obtain N charging health features | S120 |

| Input the N charging health features into a pre-trained neural network model to obtain a predicted capacity degradation value | S130 |

| Determine an SOH of the lithium battery based on the capacity degradation value | S140 |

[FIG. 2]

| Accumulated error generation | S210 |

↓

| Establish a whitenization differential equation | S220 |

↓

| Solve a predicted value of the whitenization differential equation | S230 |

↓

| Solve an error estimation value by using inverse accumulated generating operation | S240 |

↓

| Solve corrected capacity degradation for an aging cycle | S250 |

[FIG. 3]

[FIG. 4]

## INTERNATIONAL SEARCH REPORT

| International application No. |
| --- |
| **PCT/CN2024/084874** |

**A. CLASSIFICATION OF SUBJECT MATTER**

G01R31/392(2019.01)i; G01R31/378(2019.01)i; G01R31/367(2019.01)i

According to International Patent Classification (IPC) or to both national classification and IPC

**B. FIELDS SEARCHED**

Minimum documentation searched (classification system followed by classification symbols)

IPC:G01R

Documentation searched other than minimum documentation to the extent that such documents are included in the fields searched

Electronic data base consulted during the international search (name of data base and, where practicable, search terms used)

CNTXT, ENTXTC, CNKI, ENTXT, VEN: 健康度, 健康状态, 测, 充电, 恒流, 恒压, 灰色关联, 健康特征, 健康因子, 神经网络, 容量退化, 灰色模型, 误差补偿, 最小二乘法, SOH, State of Health, test, detect, measure, charge, constant current, constant voltage, grey correlation, health profile, health factor, neural network, capacity degradation, error compensation

**C. DOCUMENTS CONSIDERED TO BE RELEVANT**

| Category* | Citation of document, with indication, where appropriate, of the relevant passages | Relevant to claim No. |
| --- | --- | --- |
| PX | CN 117233638 A (SINENG ELECTRIC CO., LTD.) 15 December 2023 (2023-12-15) claims 1-10, and description, paragraphs 0005-0123 | 1-10 |
| X | CN 114580262 A (JILIN UNIVERSITY) 03 June 2022 (2022-06-03) description, paragraphs 0008-0170, and figure 3 | 1-3, 7-10 |
| Y | CN 114580262 A (JILIN UNIVERSITY) 03 June 2022 (2022-06-03) description, paragraphs 0008-0170, and figure 3 | 4-6 |
| Y | CN 114971013 A (LIAONING TECHNICAL UNIVERSITY) 30 August 2022 (2022-08-30) description, paragraphs 0007-0018 | 4-6 |
| X | CN 110187281 A (TIANJIN UNIVERSITY) 30 August 2019 (2019-08-30) description, paragraphs 0011-0068, and figure 2 | 1-3, 7-10 |
| X | CN 114397577 A (STATE GRID TIANJIN ELECTRIC POWER COMPANY et al.) 26 April 2022 (2022-04-26) description, paragraphs 0006-0138 | 1-3, 7-10 |

☑ Further documents are listed in the continuation of Box C. ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **11 July 2024** | **12 July 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2024/084874** |

### C. DOCUMENTS CONSIDERED TO BE RELEVANT

| Category* | Citation of document, with indication, where appropriate, of the relevant passages | Relevant to claim No. |
| --- | --- | --- |
| X | CN 114487890 A (CENTRAL SOUTH UNIVERSITY) 13 May 2022 (2022-05-13) description, paragraphs 0005-0079 | 1-3, 7-10 |
| X | CN 112580211 A (TIANJIN UNIVERSITY) 30 March 2021 (2021-03-30) description, paragraphs 0006-0054 | 1-3, 7-10 |
| X | 陈峥等 (CHEN, Zheng et al.). "基于健康特征提取和PSO-RBF神经网络的锂离子电池健康状态预测 (State of Health Prediction for Lithium-Ion Batteries Based on Health Feature Extraction and PSO-RBF Neural Network)" 昆明理工大学学报(自然科学版) (Journal of Kunming University of Science and Technology (Natural Science), Vol. 45, No. 6, 31 December 2020 (2020-12-31), ISSN: 1007-855X, pages 94-99 | 1-3, 7-10 |
| X | CN 117169743 A (WUXI LICLOUD TECHNOLOGY CO., LTD.) 05 December 2023 (2023-12-05) description, paragraphs 0006-0046 | 1, 7-10 |
| A | CN 113917337 A (STATE GRID FUJIAN ELECTRIC POWER CO., LTD. et al.) 11 January 2022 (2022-01-11) entire document | 1-10 |
| A | US 2022283240 A1 (WUHAN UNIVERSITY) 08 September 2022 (2022-09-08) entire document | 1-10 |

Form PCT/ISA/210 (second sheet) (July 2022)

**INTERNATIONAL SEARCH REPORT**
**Information on patent family members**

International application No.

**PCT/CN2024/084874**

| Patent document cited in search report | | | Publication date (day/month/year) | Patent family member(s) | Publication date (day/month/year) |
|---|---|---|---|---|---|
| CN | 117233638 | A | 15 December 2023 | None | |
| CN | 114580262 | A | 03 June 2022 | None | |
| CN | 114971013 | A | 30 August 2022 | None | |
| CN | 110187281 | A | 30 August 2019 | None | |
| CN | 114397577 | A | 26 April 2022 | None | |
| CN | 114487890 | A | 13 May 2022 | None | |
| CN | 112580211 | A | 30 March 2021 | None | |
| CN | 117169743 | A | 05 December 2023 | None | |
| CN | 113917337 | A | 11 January 2022 | None | |
| US | 2022283240 | A1 | 08 September 2022 | None | |

Form PCT/ISA/210 (patent family annex) (July 2022)

**REFERENCES CITED IN THE DESCRIPTION**

**Patent documents cited in the description**

- CN 202311264329